Europäisches Patentamt

(19) European Patent Office

Office européen des brevets

(11) Publication number: **0 078 890**
**A2**

(12) **EUROPEAN PATENT APPLICATION**

(21) Application number: 82106907.7

(22) Date of filing: 30.07.82

(51) Int. Cl.³: **H 01 L 21/76**
**H 01 L 21/82**

(30) Priority: 06.11.81 US 319335

(43) Date of publication of application:
18.05.83 Bulletin 83/20

(84) Designated Contracting States:
DE FR GB

(71) Applicant: Rockwell International Corporation
3370 Miraloma Avenue
Anaheim California 92803(US)

(72) Inventor: Soclof, Sidney Isaac
6419 N. Lemon Avenue
San Gabriel, CA 91775(US)

(74) Representative: Wagner, Karl H.
P.O. Box 246 Gewürzmühlstrasse 5
D-8000 Munich 22(DE)

(54) Method of fabrication of dielectrically isolated CMOS device with an isolated slot.

(57) A method of fabricating an integrated circuit on a body of semiconductor material having a major surface layer of (110) crystallographic orientation by etching vertical slots into the layer to form distinct islands; depositing dopant species in predetermined ones of the silicon islands so that the major surface and exposed edges of ones of the islands become second conductivity type; and thermally oxidizing the exposed surface portions of the body so that oxide fills the vertical slots between the islands.

EP 0 078 890 A2

Croydon Printing Company Ltd.

**0078890**

## METHOD OF FABRICATION OF DIELECTRICALLY ISOLATED CMOS DEVICE WITH AN ISOLATION SLOT

### BACKGROUND OF THE INVENTION

### Field of the Invention

The invention relates to the fabrication of semiconductor devices, and in particular to a method of fabrication of dielectrically isolated CMOS devices.

### Description of the Prior Art

Complementary MOS (CMOS) integrated circuits, and their method of fabrication, are well known in the art of semiconductor device technology. One type of CMOS device is implemented on bulk silicon. Complementary MOS integrated circuit on bulk silicon requires that the N and P channel devices be electrically isolated from each other. The prior art technique for accomplishing this electrical isolation is by junction isolation of either device.

Most currently available integrated circuits are so-called monolithic integrated circuits. This term is used because the IC structure contains a large number of active and passive devices integrated on a block or monolith of semiconductor material. Electrical connections between these active and passive devices are generally made on a surface of the semiconductor block of material. Junction isolation is probably the most widely practiced manner of isolating devices or circuits in the integrated circuit from each other. For example, active P type diffusions are customarily used to isolate conventional and P-N bipolar devices from one another and from other devices such as the resistors and capacitors. Such junction isolation is also used in integrated circuits utilizing field effect transistor devices. More detailed descriptions of junction isolation may be found in U.S. Pat. Nos. 3,319,311; 3,451,866; 3,508,209 and 3,539,876.

Although junction isolation has provided good electrical isolation in integrated circuits, at the present stage of the development of the integrated circuit art towards very high speed integrated circuits (VHSICs) and very large scale integrated (VLSI) circuits, there is an increasing demand for faster switching circuits. It has long been recognized that the capacitive effect of the isolating P-N junctions has a slowing effect on the switching speed of the integrated circuits. Up to now, the switching demands of the integrated circuits have been of a sufficiently low frequency that the capacitive effect in junction isolation has presented no major problems. However, with the higher frequency switching demand which can be expected in the field in the future, the capacitive effect produced by junction isolation may be an increasing problem. In addition, junction isolation requires relatively large spacing between devices, and, thus, relatively low device densities which is contrary to higher device densities required in large scale integration. Junction isolation also tends to give rise to parasitic transistor effects between the isolation region and its two abutting regions.

More particularly, the isolation junction creates parasitic bipolar transistors which, in combination, form silicon controlled rectifiers (SCR). These devices trigger to the "on" stage conditions upset the normal voltage bias operating range for normal IC operation. Once triggered, the circuit "latches up" and recovery can only be obtained by removing power to the device. Various approaches to the problem of "latch-up" have been considered in the prior art, the most pertinent of which are believed to be RCA Technical Note 876, which describes the use of guard rings to eliminate parasitic SCR transistors and latching, and U. S. Patent No. 4,203,126 (Yim et al), which utilizes a buried layer along with an epitaxial N- layer on an N substrate, together with guard rings.

81E31

- 3 -

In recent years there has been an interest in integrated circuits with dielectric isolation instead of junction isolation. In such dielectrically isolated circuits, the semiconductor devices are isolated from each other by insulative dielectric materials.

One such dielectric isolation technique in integrated circuits has been formed by etching channels in a semiconductor member corresponding to the isolation regions. This leaves an irregular or channeled surface over which a substrate, usually a composite of a thin dielectric layer forming the interface with the semiconductor member covered by a thicker layer of polycrystalline silicon is deposited. Then the other surface of the semiconductor member is either mechanically ground down or chemically etched until the bottom portions of the previously etched channels are reached. This leaves the structure wherein a plurality of pockets of semiconductor material surrounded by the dielectric layer are supported on the polycrystalline silicon substrate and separated from each other by extensions or fingers of the polycrystalline substrate. Such structures have been described in the prior art in patents such as U.S. Pat. Nos. 3,391,023; 3,332,137; 3,419,956; 3,372,063, 3,575,740; 3,421,205; 3,423,258; 3,423,255 and 3,478,418.

Dielectric insulated regions are used adjacent to MOS devices for isolation in U.S. Patent 4,053,926 (Burr et al).

A more recent technique for fabricating a dielectrically isolated CMOS device described in copending U. S. Patent Application Serial Number 305,247, and assigned to a common assignee, describes the steps of depositing an epitaxial silicon layer of N type on an N+ type substrate; etching V-grooves through the N type epitaxial silicon layer to form a plurality of silicon islands; selectively implanting edges of the silicon islands; oxidizing to electrically isolate the islands; and implanting P+ and N+ in selective regions of the islands.

SUMMARY OF THE INVENTION

Briefly, and in general terms, the invention consists of a method for fabricating a dielectrically isolated CMOS device including the steps of providing a silicon body having a major surface layer with a crystal orientation of (110); etching a slot substantially normal to the surface through the silicon surface layer to form a plurality of spaced apart silicon islands; selectively implanting edges of the silicon islands; oxidizing the silicon body to electrically isolate the islands; and implanting P+ and N+ in selective regions of the islands.

More particularly, the invention consists of a method of fabricating an integrated circuit on a body of semiconductor material of a first conductivity type and a first dopant concentration comprising the steps of providing a layer of semiconductor material of (110) crystallographic orientation on a major surface; defining an oxide inhibiting masking pattern on the major surface where distinct silicon islands are to be formed; etching openings in the layer at regions defined by the pattern, the openings extending substantially normal to said surface; depositing dopant species in predetermined ones of the silicon islands so that the major surface and exposed edges of the ones of the islands becomes second conductivity type; thermally oxidizing the exposed surface portions of the body of semiconductor material so that oxide fills the openings; removing the oxide inhibiting masking pattern; thermally oxidizing the exposed portions of said body of semiconductor material to form a thin oxide layer over the major surface of the silicon islands; selectively providing first

0078890

- 5 -

and second dopant species through said thin oxide layer for forming
active regions of transistor devices; and selectively removing
portions of said thin oxide layer to form contact areas to said
active regions.

The novel features which are considered as characteristic for
the invention are set forth in particular in the appended claims.
The invention itself, however, both as to its construction and its
method of operation, together with additional objects and advantages
thereof will be best understood from the following description of
specific embodiments when read in connection with the accompanying
drawings.

BRIEF DESCRIPTION OF THE DRAWINGS

Figure 1 is a highly simplified cross-sectional view of a CMOS
bulk device as is known in the prior art;

Figure 2a is a highly simplified block schematic diagram of a
lateral parasitic bipolar transistor associated with the CMOS bulk
device of Figure 1;

Figure 2b is a highly simplified block schematic diagram of a
vertical and horizontal parasitic bipolar device associated with the
structure of Figure 1;

Figure 2c is a schematic diagram of the parasitic bipolar
transistors shown in block schematic form in Figure 2b;

Figure 3 is a cross-sectional view of the device structure of
a dielectrically isolated CMOS on bulk silicon device according to one
prior art technique;

Figure 4 is a cross-sectional view of the device structure of a
dielectrically isolated CMOS on bulk silicon device with an isolation
slot according to the present invention;

Figure 5a is a cross-sectional view of the N-type (110) silicon
substrate used as the first step in the fabrication of the device
according to the present invention;

Figure 5b shows the second step in the fabrication of the devive
according to the present invention consisting of nitride masking and
etching the isolation slots;

Figure 5c shows the third step in the fabrication of the device according to the present invention including oxidizing the surface, stripping the nitride, growing gate oxide, and depositing and patterning gate electrodes;

Figure 5d shows the fourth step in the fabrication of the device according to the present invention including implanting N+ and P+ regions, and depositing a protective glass layer over the device;

Figure 6 is a top plan view of the CMOS circuit with parallel isolation slots according to the present invention; and

Figure 7 is a top plan view of another embodiment of the CMOS circuit according to the present invention with parallel intersecting isolation slots dividing the surface of the wafer into silicon island regions of active devices.

DESCRIPTION OF THE PREFERRED EMBODIMENTS

The present invention is concerned with a method of fabricating CMOS on bulk silicon integrated circuits which minimizes the "latch-up" effect with no compromise in device density.

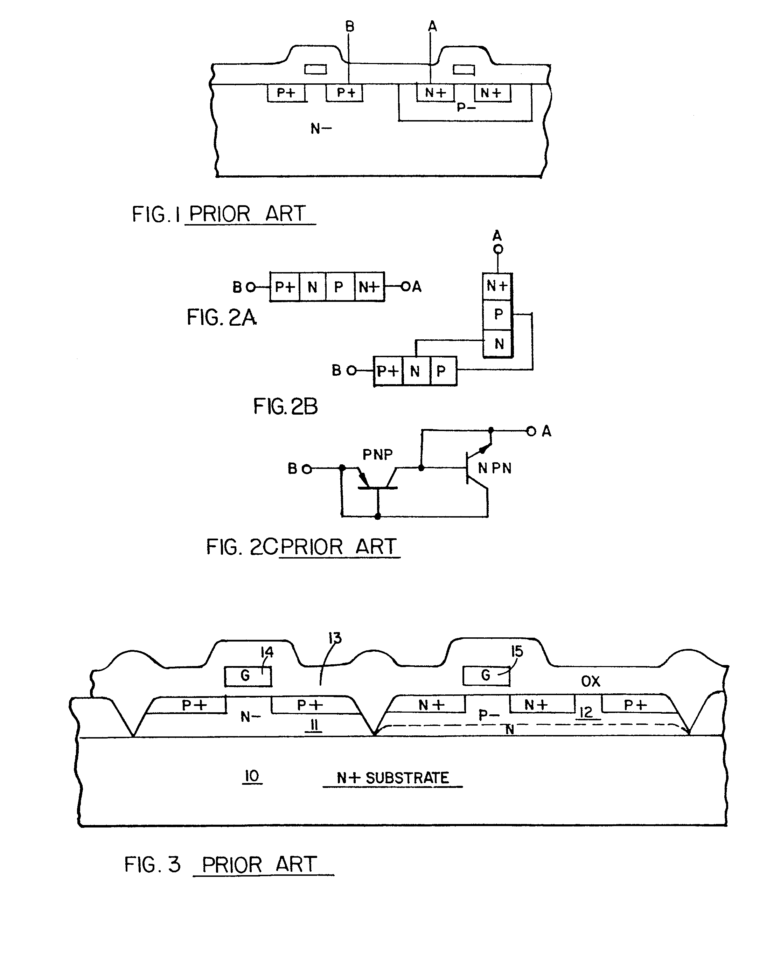

The "latch-up" effect in CMOS bulk silicon has been described in several recent papers and publications. ("Latch-Up in CMOS Integrated Circuits," B. L. Gregory et al, IEEE Trans. Nuclear . Science, Vol. NS-20, pp. 293-299, 1973, J. F. Leary & R. A. Poll, "Radiation-Induced Integrated Circuit Latch-Up," IEEE Trans. Nuc. Science, Vol. NS 16, p. 96, December 1969.) This phenomena is apparently a consequence of the method in which the devices are fabricated. Figure 1 illustrates a cross-sectional view of a typical CMOS device structure. Note that two bipolar transistors are also present: an N+ P N and a P+ N P transistor. The two transistors are interconnected by base and collector to form an SCR structure, as suggested in Figure 2a. Figure 2b is a highly simplified block schematic diagram of a vertical and horizontal parasitic bipolar device associated with the structure of Figure 1. Figure 2c is a schematic diagram of the parasitic bipolar transistors shown in block schematic form in Figure 2b.

The doping concentrations in the various regions are in the proper ranges for effective SCR action. Consequently, if the proper biasing conditions exist the device will trigger into the negative resistance region and is only recoverable by powering down. Previous attempts to reduce the SCR effect have centered on reducing lifetime in the base region of the bipolars, increasing distance (device separation) to increase trigger voltage levels, guard ring structures, and add additional contracts to wells and substrate in order to stabilize the potential in critical regions. These remedies have enhanced the immunity of CMOS bulk to latch-up but have not cured it. In addition, the device separation and guard rings solution results in a less than optimum packing density. Future IC devices (1 micron dimensions) will further magnify the separation requirements necessary to retard latch-up effects.

One prior art device structure makes use of dielectric isolation in combination with a degenerate substrate, and is shown in Figure 3. Note that the parasitic SCR structure is blocked by (a) the N+ substrate and (b) the oxide isolation. The N+ substrate serves as a high recombination medium thereby preventing carriers from reaching the collector. The oxide isolation forces the carriers to the N+ substrate. No SCR action is possible, hence, no latch-up.

Turning more specifically to the features of Figure 3, the Figure shows a substrate 10, preferably composed of N+ conductivity type doped silicon, and two silicon islands 11 and 12 disposed on the major surface of the substrate 10. The first island 11 is of N- conductivity type, while the second island 12 is of P- conductivity type. The two islands are electrically and physically separated from one another by a layer of dielectric material 13 which covers both the upper surface and the side surface of the silicon islands 11 and 12. In the one embodiment the dielectric 13 is silicon oxide.

The Figure also shows two P+ active regions in the silicon island 11 with a gate element 14 disposed over the channel extending between the two P+ active elements. The silicon island 12 includes two N+ active regions with a gate 15 disposed over the channel between the two N+ regions. The silicon island 12 also includes a P+ surface region which is used to make electrical contact with the P- region in the silicon body 12.

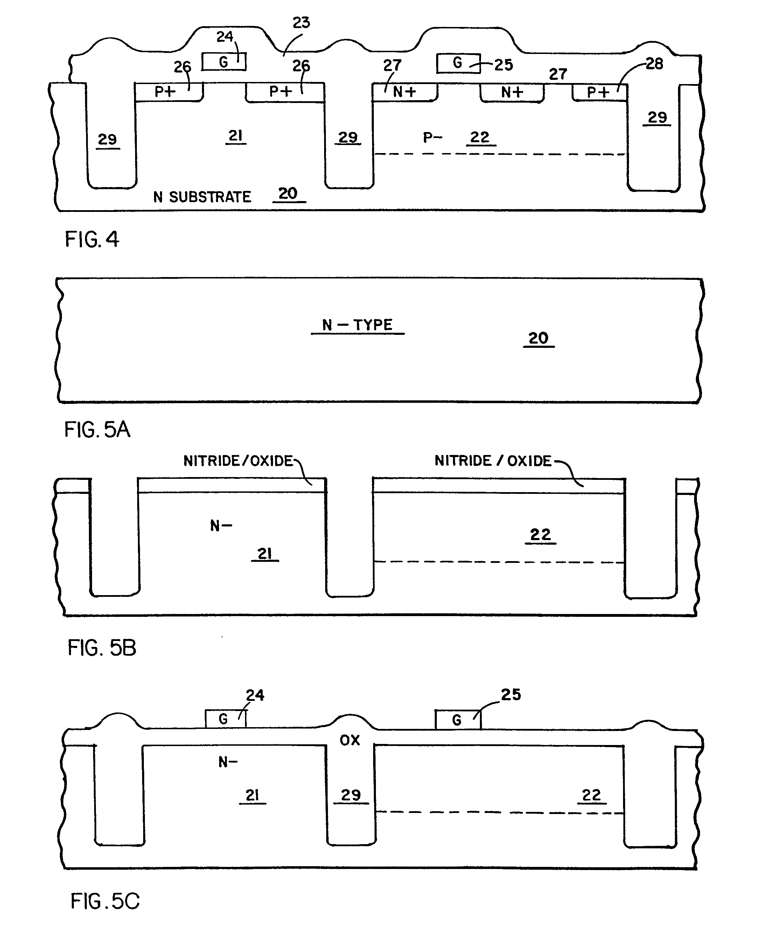

Turning now to Figure 4, there is shown a cross sectional view of the device structure of a dielectrically isolated CMOS on bulk silicon device with an isolation slot according to the present invention.

Turning more specifically to the features of Figure 4, the Figure shows a substrate 20, preferably composed of N conductivity type doped silicon and two silicon isands 21 and 22 disposed on the major surface of the substrate 20. The major surface preferably has a (110) crystallographic orientation. The first island 21 is of N conductivity type, the same as the substrate, while the second island 22 is of P- conductivity type. The two islands are electrically and physically separated from one another by a layer of dielectric material 23 which entirely covers both the upper surface and the side surface of the silicon islands 21 and 22. In the preferred embodiment the dielectric 23 is silicon oxide.

The Figure also shows two P+ active regions 26 in the silicon island 21 with a gate element 24 disposed over the channel extending between the two P+ active elements. The silicon island 22 includes two N+ active regions 27 with a gate 25 disposed over the channel between the two N+ regions. The silicon island 22 also includes a P+ surface region 28 which is used to make electrical contact with the P- region in the silicon island 22.

The islands 21 and 22 are separated by isolation slots 29 or 3C which are grooves normal to the surface and extending into the substrate 20, along planes corresponding to the (111) crystallographic planes.

Turning next to Figures 5a through 5d, there is shown a sequence of steps for fabricating the CMOS on bulk structure according to the present invention. Turning to Figure 5a in particular, the first step in the fabrication of the structure according to the present invention is shown. The Figure shows the cross-section of an N conductivity type substrate which has a major surface with a (110) crystallographic orientation.

Turning now to Figure 5b, in order to isolate the discrete devices, a thin protective film, preferably a dielectric material such as silicon nitride is deposited, and masked appropriately. After masking, the nitride is etched, followed by another orientation-dependent etch through the substrate to a depth of typically 10-30 um. A suitable orientation-dependent etchant is potassium hydroxide.

Turning next to Figure 5c, one then proceeds to oxidize the wafer to form the isolated regions. Typically the oxidation can be performed in a steam environment at 1,000° C. The oxide thickness should be in the order of 10,000 Angstroms. At this time one now has the silicon islands separated laterally by oxide regions. At this point, the nitride mask is removed by a chemical etch technique involving hot phosphoric acid.

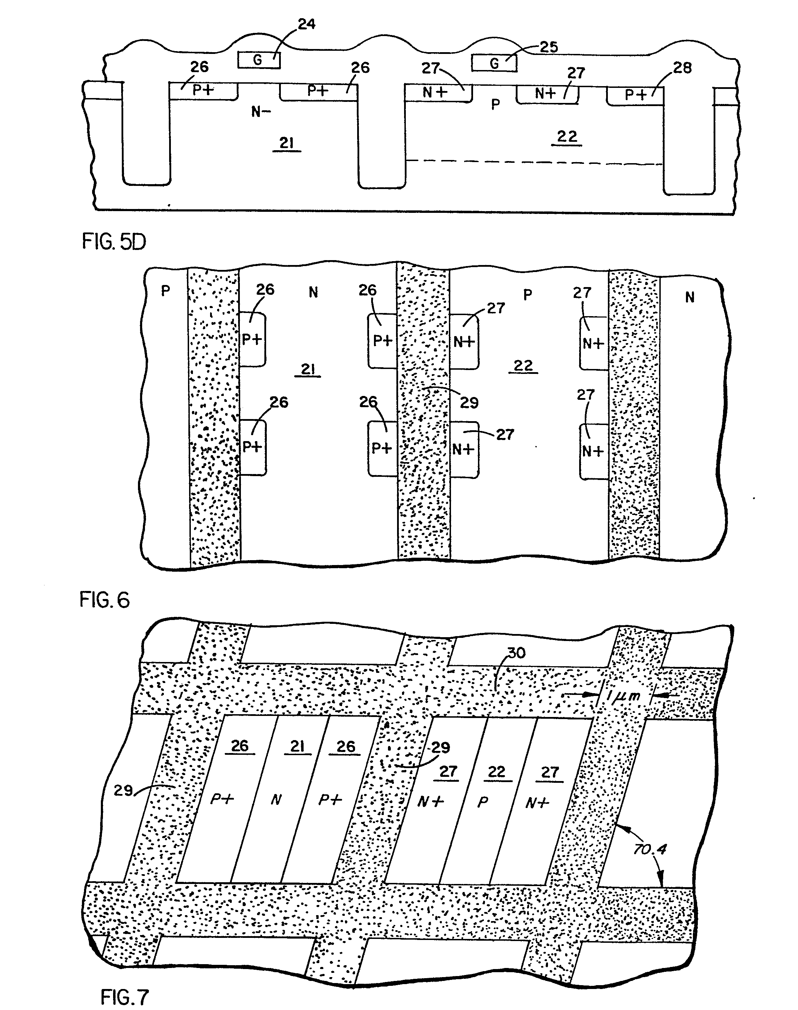

Turning next to Figure 5d, there is shown a cross-sectional view of the structure during the final processing step according to the present invention. At this time the P channel is implanted with phosphorus to adjust its final threshold, and the regions which will be the N channel regions are implanted with boron to form a deep P well. The P well preferably extends approximately two-thirds the depth of the height of the silicon island, or about 0.6 micron.

Once the p-well and isolation oxide is established, the gate oxide is grown in a clean furnace, either in steam or in dry oxygen. The thickness of the gate oxide will be selected depending upon the size of the device and the performance required from the circuit. Typical gate oxide thicknesses will range from 400 to 1000 Angstroms. Immediately after the gate oxide is grown a layer of polysilicon is deposited, usually N+, although it can be polysilicide or P+ or combinations of both, as well.

81E31

- 10 -

The gates are defined in the standard photolithographic manner. They are etched either by plasma or wet etching, depending upon the geometries desired. Following the gate patterning the source and drain implants are placed into position through masking operations. A typical P channel implant involves a double implant at two energies, with a relative high dose. The dose should be such as to render the source and drain regions degenerate in nature. The penetration of the implant should be in the order of 1/2 micron for both the source and drain regions, as well as the contact to the P well. Once the implants are in position, an implanted anneal may be performed.

The implant anneal is followed by a deposition of a phosphorous silicate glass, typically of the order of 6000-8000 Angstroms in thickness. The glass is reflowed to ensure smooth contouring of the surfaces. Reflow is done by a furnace operation of $1000^o$ C for 20 minutes.

The phosphorous glass is in the order of 7% phosphorus. At this percentage, the phosphorous glass begins to soften under the described process conditions and begins to flow, thereby rounding off all corners and filling crevices. A subsequent photolithographic step then opens up areas in which the contacts to the source, drain and gate areas are to be made. The contacts are etched through the phosphorous glass layer down to the silicon by means of a hydroflouric acid etch. The photoresist is removed, metal is deposited, followed by a photolithographic process to define the metal and then finally a sintering operation which sinters the metal into the contact areas. The entire structure is then covered by a low temperature vapox glass which ensures against metal scratching during subsequent processing.

While the invention has been illustrated and described as embodied in a method of fabrication of dielectrically isolated CMOS devices with an isolation slot, it is not intended to be limited to the details shown, since various modifications and structural changes may be made without departing in any way from the spirit of the present invention.

- 11 -

It will be obvious to those skilled in the art that the semiconductor device according to the present invention can be implemented with various semiconductor technologies and different combinations of known process steps, and that the preferred embodiments illustrated here are merely exemplary. The depth of penetration of the various zones and regions and in particular the configuration and distance between the active zones of the transistor devices, as well as the concentrations of dopant species, and/or their concentration profiles, can be chosen depending upon the desired properties. These and other variations can be further elaborated by those skilled in the art without departing from the scope of the present invention.

The present invention is moreover not restricted to the particular embodiments of a method of fabrication of dielectrically isolated CMOS devices described. For example, it may be pointed out that semiconductor materials other than silicon, for example, $A_{III}-B_V$ compounds may be used. Furthermore, the conductivity types in the embodiment may be interchanged and corresponding to such change, the polarity of the respective operating voltages adapted. Moreover, the voltage level and the static or dynamic nature of the signals applied to the various terminals and gates of the device, as well as the voltage sources, may be suitably selected as desired for a particular application. Other types of semiconductor circuits including bipolar junction field effect transistors, MNOS (metal electrode-silicon nitride, silicon oxide-semiconductor), MAOS (metal aluminum oxide, silicon oxide, semiconductor), MAS (metal, aluminum oxide, semiconductor), floating gate FETs, and AMOS FETs (avalanche MOS FETs), may be used as well.

Without further analysis, the foregoing will so fully reveal the gist of the present invention that others can, by applying current knowledge, readily adapt it for various applications without omitting features that, from the standpoint of prior art, fairly constitutes essential characteristics of the generic or specific aspects of this invention, and, therefore, such adaptations should and are intended to be comprehended within the meaning and range of equivalence of the following claims.

What is claimed is:

1.    A method of fabricating an integrated circuit on a body of semiconductor material comprising the steps of:

providing a layer of semiconductor material of said first conductivity type having a major surface of (110) crystallographic orientation;

defining an etch resistant and oxide inhibiting masking pattern on said major surface where distinct islands are to be formed;

etching a first set of parallel openings in said body of semiconductor material at regions defined by said pattern, said openings extending substantially normal to said layer;

depositing dopant species in predetermined ones of said silicon islands so that the major surface and exposed edges of said ones of said islands becomes second conductivity type;

thermally oxidizing the exposed surface portions of said body of semiconductor material so that oxide fills said openings;

removing said oxide inhibiting masking pattern;

thermally oxidizing the exposed surface portions of said body of semiconductor material to form a thin oxide layer over the major surface of said islands;

selectively providing first and second dopant species through said thin oxide layer for forming active regions of transistor devices; and

selectively removing portions of said thin oxide layer to form contact areas to said active regions.


2.    A method as defined in claim 1 wherein said layer of semiconductor material type is N-type.


3.    A method as defined in claim 1, wherein said oxide inhibiting masking pattern comprises a silicon nitride layer.


4.    A method as defined in claim 1, wherein a dopant species which is deposited in predetermined ones of said silicon islands is P type.

5. A method as defined in claim 1, wherein said step of selectively providing first and second dopant species provides a first dopant species of second conductivity type in silicon islands of first conductivity type, and a second dopant species of first conductivity type in silicon islands of second conductivity type, thereby forming source and drain regions of a field effect transistor.

6. A method as defined in claim 1, wherein said step of selectively providing dopant species utilizes a gate element as a mask.

7. A method as defined in claim 1 further comprising the step of etching a second set of parallel openings in said body of semiconductor material, said second set of openings extending transversely to said first set and intersecting said first set at an angle of $70.4^{\circ}$.

8. A method as defined in claim 1, wherein said etching step utilizes an orientation-dependent etchant.

0078890

FIG. I PRIOR ART

FIG. 2A

FIG. 2B

FIG. 2C PRIOR ART

FIG. 3 PRIOR ART

FIG. 4

FIG. 5A

FIG. 5B

FIG. 5C

FIG. 5D

FIG. 6

FIG. 7